# EUROPEAN PATENT SPECIFICATION

(11) **EP 0 580 019 B1**
(45) Date of publication and mention of the grant of the patent: **26.05.1999**
(21) Application number: 93110852.6
(22) Date of filing: 07.07.1993
(51) Int. Cl.: C30B 25/02, C23C 14/06, C23C 14/58, C23C 8/08

(54) **Oriented polycrystalline thin films of transition metal chalcogenides**
Orientierte polykristalline dünne Filme aus Übergangsmetallchalcogeniden
Films minces et orientés polycristallines en chalcogénure d'un métal de transition

(30) Priority: 08.07.1992 IL 10244092; 26.01.1993 IS 10451393
(43) Date of publication of application: 26.01.1994
(73) Proprietor: YEDA RESEARCH AND DEVELOPMENT COMPANY, LTD., Rehovot 76100 (IL)
(72) Inventor: Tenne, Reshef, 76231 Rehovot (IL); Hodes, Gary, 73270 Gezer (IL); Margulis,Lev, 76381 Rehovot (IL)
(74) Representative: VOSSIUS & PARTNER

(56) References cited:
- THIN SOLID FILMS vol. 200, no. 1 , 1 May 1991 , THE NETHERLANDS pages 157 - 164 J.JÄGER-WALDAU ET AL 'WSe2 thin films prepared by soft selenisation'
- THIN SOLID FILMS vol. 189, no. 2 , 15 August 1990 , THE NETHERLANDS pages 339 - 345 J.JÄGER-WALDAU ET AL 'composition and morphology of MoSe2 thin films'
- THIN SOLID FILMS vol. 154, no. 1/2 , 12 November 1987 , THE NETHERLANDS pages 309 - 322 P.D.FLEISCHAUER 'fundamental aspects of the electronic structure, materials properties and lubrication performance of sputtered MoS2 films'
- ADVANCED MATERIALS vol. 5, no. 5 , May 1993 , WEINHEIM,DE pages 386 - 388 R. TENNE ET AL 'fullerene like nanocrystals of tungsten disulfide'

## Description

The present invention relates to specially oriented polycrystalline thin films of transition metal chalcogenides with layered structure and to methods for their fabrication and more particularly, to polycrystalline thin films of semiconducting transition metal dichalcogenides which are oriented so that the basal plane of the crystallites is exclusively or nearly exclusively parallel to the substrate surface, and to methods for their fabrication.

There has been recent interest in the preparation of polycrystalline thin films of semiconducting transition metal dichalcogenides, e.g., WS₂, WSe₂, MoS₂ and MoSe₂. Possible applications include electrochemical and photovoltaic solar cells (see H. D. Abruna and A. J. Bard, J. Electrochem. Soc., 129 (1982) 673; G. Djemal et al., Sol. Energy Mater., 5 (1981) 403). Interest also exists in use of such as thin films in solid lubrication, such in high or low temperature environments or under ultra high vacuum where liquid lubricants are not suitable (see H. Dimigen et al., Thin Solid Films, 64 (1979) 221). Other possible applications involve battery cathodes (see J. Rouxel and R. A. Brec, Rev. Mater. Sci., 16 (1986) 137), and catalysis (see R. R. Chianelli, Catal. Rev. Sci. Eng., 26 (1984) 361). These thin films possess a layered-type structure with strong anisotropy of their mechanical and electrical properties. The chemical bonding is much stronger within the layers (covalent bonds) than between them (Van der Waals (VdW) bonds) (see J. A. Wilson and A. D. Yoffe, Adv. Phys., 18 (1969) 193). Polycrystalline thin films of transition metal chalcogenides ordinarily grow with a lamellar structure in which the basal (or VdW) planes are perpendicular to the substrate (see R. Bichsel and F. Levy, Thin Solid Films, 116 (1984) 367; P. A. Bertrand, J. Mater. Res., 4 (1989) 180). However, for photovoltaic as well as for solid lubrication applications, growth with the VdW planes parallel to the substrate is desired (see P. D. Fleischauer, Thin Solid Films, 154 (1987) 309).

Polycrystalline thin films of transition metal dichalcogenides have been reported to be prepared mainly by sputtering the transition metal dichalcogenides (see R. Bichsel and F. Levy, Thin Solid Films, 116 (1984) 367; A. Mallouky and J. C. Bernede, Thin Solid Films, 158 (1988) 285), by electrochemical deposition (see S. Chandra and S. Sahu, J. Phys. D., 17 (1984) 2115) and by soft selenization or sulfurization as was recently reported by Jager-Waldau et al. for tungsten (see A. Jager-Waldau and E. Bucher, Thin Solid Films, 200 (1991) 157) and molybdenum (see A. Jager-Waldau et al., Thin Solid Films, 189 (1990) 339) diselenides and disulfides.

In the soft selenization method, thin sputtered tungsten or molybdenum films were reacted with selenium in a closed tube system for tens to hundreds of hours. As a result, two types of orientations were obtained, with the basal plane of the crystallites being oriented either predominantly perpendicular (hereinafter Type I) or predominantly parallel (hereinafter Type II) to the substrate surface.

Thin films of materials such as MoS₂, MoSe₂, MoTe₂, WS₂, WSe₂, ZrS₂, ZrSe₂, HfS₂, HfSe₂, PtS₂, ReS₂, ReSe₂, TiS₃, ZrS₃, ZrSe₃, HfS₃, HfSe₃, TiS₂, TaS₂, TaSe₂, NbS₂, NbSe₂ and NbTe₂ have been studied for both their photovoltaic and tribological properties. It has been found in both cases that thin films with Van der Waals (VdW) planes parallel to the substrate (Type II) are much preferable to those with VdW planes perpendicular to the substrate (Type I). This is especially true for photovoltaic applications where Type I structures normally exhibit very poor photovoltaic activity and where even a small percentage of Type I orientation in a predominantly Type II structure can severely degrade photovoltaic performance. It is believed that Type I structures act as recombination sites and as centers for electrochemical corrosion (see H. J. Lewerenz et al., J. Am. Chem. Soc. 102 (1980) 1877).

It has heretofore been unknown how to make polycrystalline thin films of transition metal chalcogenides which are exclusively, or nearly exclusively of Type II.

Thus, it is the object of the present invention to provide polycrystalline thin films of semiconducting transition metal dichalcogenides, and methods for making these thin films, which will be oriented exclusively or nearly exclusively as a Type II structure.

This object has been achieved by a method of preparing a polycrystalline thin film of a transition metal chalcogenide, or mixtures thereof, with layered structure, of type II orientation on a substrate, comprising: (a) depositing a layer of a transition metal material selected from a transition metal, a compound containing a transition metal and mixtures thereof on the substrate; and (b) heating the layer in an open system under a gas flow containing one or more chalcogen materials for a time sufficient to allow the transition metal material and the chalcogen material to react and form the oriented polycrystalline thin film, said thin film being hearly exclusively oriented in said type II orientation.

Also according to the present invention there is provided an oriented polycrystalline thin film of a transition metal chalcogenide made by the above method.

According to the present invention there is provided a polycrystalline layered thin film of a transition metal chalcogenide, or mixtures thereof, on a substrate, whose Van der Waals planes are nearly exclusively, parallel to the substrate surface.

Further yet according to the present invention there is provided a rolled-up structure substantially circular in cross-section, made up of layered transition metal chalcogenides. This structure, which has been variously termed 'microtubular', 'nanotubular', 'fullerene-like', 'faux fullerene' (as in Sci. Am., February 1993, p. 24), or 'nested polyhedra' may be obtained by the method of the invention.

According to further features in preferred embodiments of the invention described below, the transition metal material is a transition metal, such as tungsten, molybdenum, zirconium, hafnium, platinum, rhenium, titanium, tantalum and niobium preferably tungsten or molybdenum, or a compound containing a transition metal, while the chalcogen material is a chalcogen, such as sulfur, selenium or tellurium, preferably sulfur or selenium, or a compound containing a chalcogen.

According to still further features in the described preferred embodiments the deposition is accomplished by sputtering, by vacuum evaporation, by chemical solution deposition or by electrodeposition.

According to yet further features in the described preferred embodiments the heating is conducted under reducing conditions, preferably using a gaseous atmosphere which includes hydrogen sulfide or sulfur and forming gas.

In preferred embodiments the heating takes place at a sufficiently high temperature and at a sufficiently low sulfur concentration as to form a thin layer whose crystallites have a basal plane which is oriented nearly exclusively parallel to the substrate surface, where nearly exclusively is meant to indicate more than 95% of the chains parallel to the substrate surface, preferably over 99%, most preferably over 99.9%.

The present invention successfully addresses the shortcomings of the presently known methods by providing a method which allows a thin layer to be constructed which is made up nearly exclusively of crystallites having a basal plane which is oriented parallel to the substrate surface.

The present invention discloses the formation of highly oriented films of transition metal chalcogenides, such as WS₂, WSe₂, MoS₂ and MoSe₂. The oriented thin films are grown by chalcogenizing thin tungsten or molybdenum films, using S, Se, Te, or their compounds.

According to the present invention, thin tungsten or molybdenum films are deposited onto a suitable substrate and then reacted at temperatures from 500 to 1,100°C in an open system under a gas flow consisting of a mixture of H₂S and forming gas.

The onset of the reaction between tungsten and H₂S to give WS₂ thin films was found to depend on the substrate. For example, for quartz substrate it was found to be 650°C. Orientation of the WS₂ crystallites could be controlled by choice of reaction temperature and sulfur concentration in the gas flow. For example, with quartz substrate Type I structure was obtained from about 500°C to about 850°C while Type II was obtained from about 950°C to about 1,100°C. Mixtures of Type I and Type II were obtained for temperatures between about 850°C and about 950°C. Low reaction temperatures (up to 900°C) and high sulfur concentrations lead to films where the Van der Waals planes are perpendicular to the substrate, while high temperatures (more than 950°C) and low sulfur concentrations result in Van der Waals planes being parallel to the substrate.

These results may be explained as being the result of competition between the reaction rate and the rate of crystallization. The importance of these results lies in the fact that the latter orientation is needed for solar cells and optimum lubrication uses, yet it is the former which has been commonly encountered in the majority of reported cases.

The invention is herein described, by way of example only, with reference to the accompanying drawings wherein:

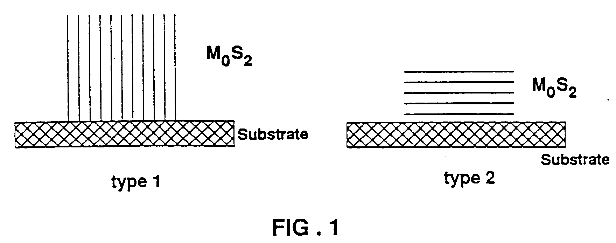

FIG. 1 is a schematic depiction of Type I and Type II orientation of layers of polycrystalline thin films on a substrate;
FIG. 2a is transmission electron microscope (TEM) view of microtubules of WS₂ of a nested polyhedra structure according to the present invention;
FIGs. 2b and 2c are TEM views of a nested polyhedra structure of WS₂ according to the present invention;
FIGs. 3 and 4 are two TEM views of MoS₂ nested polyhedra structures made as described in Example 7 -- a hollow structure (Figure 3) and Mo-filled structure (Figure 4);
FIGs. 5 and 6 are two X-ray diffraction spectra as described in Example 8.

The present invention is of a method of forming a highly oriented thin polycrystalline thin layer which is particularly useful in photovoltaic and in lubrication applications. Specifically, the present invention can be used to create thin layers in which the layers lie nearly exclusively, parallel to the plane of the substrate.

Films of MX₂, where M is Mo, or W and X is S, Se or Te, prepared by annealing sputter-deposited tungsten on quartz in flowing H₂X or elemental X vapor exhibit different crystal textures depending on the preparation conditions. Low chalcogenizing temperatures lead to exclusively or nearly exclusively Type I texture (VdW planes vertical) which is the texture usually obtained when films of this, or similar materials, are prepared by various methods. Higher temperatures give Type II texture (VdW planes parallel to the substrate, which is the desirable texture in many cases) with either very small amounts (about 1%) of vertical VdW plane component (for high chalcogen concentration in the gas flow) or no TEM-measurable amounts of this component for low chalcogen concentrations. It is believed that the phenomenon is the result of competition between the reaction rate to MX₂ and the rate of crystallization of the film. A slow deposition rate of the sputtered M films leads to high amounts of Type I texture, even at 1000°C, which may be due to impurities in the slowly growing film.

In a process according to the present invention, a polycrystalline thin film of a desired orientation on a substrate is formed by first depositing a layer of a transition metal material on the substrate. Any suitable substrate may be used. Preferably, the substrate is quartz, glass or titanium. The substrate may also be tungsten or molybdenum foils.

It has been discovered that the substrate plays an important role in determining both the temperature at which reaction between, for example, tungsten and H₂S occurs and the orientation of the WS₂ film. In general, the WS₂ phase nucleates from the metastable WS₃ amorphous phase. For glass substrates, reaction occurs at 400°C. The metastable amorphous WS₃ phase is first formed and it decomposes with the formation of the stable WS₂ phase. The WS₂ film exhibits predominantly, although not exclusively, Type II orientation at 500°C. For quartz substrates, reaction occurs at 650°C and the orientation is predominantly Type I below 950°C and nearly exclusively Type II at higher temperatures. Molybdenum substrates give Type I orientation even at 1000°C and bulk tungsten (or tungsten sputtered onto tungsten) give randomly oriented WS₂. Without in any way limiting the scope of the present invention, it is suggested that the difference between glass and quartz substrates is due to the stronger bonding of the W and WS₂ to the quartz.

The transition metal material may be a transition metal or a compound containing a transition metal, or a mixture of transition metals and/or compounds containing a transition metal, such as tungsten, molybdenum, zirconium, hafnium, platinum, rhenium, niobium, tantalum and titanium,. Preferably, the transition metal is tungsten or molybdenum, or mixtures thereof.

Deposition of the transition metal or transition metal compound onto the substrate may be accomplished in any suitable way. These may include sputtering, vacuum evaporation, chemical solution deposition and electrodeposition.

After the deposition of the layer of transition metal material, the layer is heated in a gaseous atmosphere containing a chalcogen material which may be one or more chalcogens and/or one or more compounds containing one or more chalcogens. Preferably, the chalcogen material is sulfur or selenium or mixtures thereof.

Heating is continued at a sufficiently high temperature and for a sufficiently long time to allow the transition metal material to react with the chalcogen material and form the oriented polycrystalline thin film.

Optimal temperatures and durations of heating to be used depend on the precise nature of the reactants and on the desired orientation of the polycrystalline layers.

The heating is preferably carried out under reducing conditions. The gaseous atmosphere under which the reaction is carried out preferably includes H₂X or elemental X and forming gas.

The heating takes place at a sufficiently high temperature and at a sufficiently low chalcogen concentration for the formation of a thin layer whose crystallites have a basal plane which is oriented nearly exclusively parallel to the substrate surface. The suitable temperature ranges depend on the nature of the chalcogen and the transition metal, as well as on the substrate. Typically, the heating temperature is in the range of from about 600°C to about 1,100°C. The precise temperature ranges depend on the substrate used and on whether it is desired to produce Type I or Type II structures. For example, for a quartz substrate, Type I structures are obtained at temperatures below 950°C while Type II structures are achieved at temperatures above 950°C. The suitable chalcogen concentration ranges depend on the nature of the chalcogen and the transition metal, as well as on the substrate. E.g., for sulfur, the concentration is in the range of from one or a few ppm to about 10%.

The principles and operation of a method and product according to the present invention may be better understood with reference to the examples and descriptions below, including the accompanying drawings. A number of examples are given to illustrate various aspects of the present invention. The discussion which follows concentrates on the WS₂ and MoS₂ system, it being understood that this discussion is illustrative only and is not intended to limit the scope of the present invention to that system.

### EXAMPLE 1

Thin films of molybdenum (about 50 nm thick) were ion beam sputtered onto quartz slides, at an argon pressure (in the chamber) of 0.0267 Pa (2 x 10⁻⁴ Torr). The sputtering rate was about 10 nm min⁻¹. The samples were reacted in an open quartz furnace with forming gas (5% H₂, 95% N₂, 50 cm³ min⁻¹ and residual sulfur on the walls of the quartz tube). The reaction temperature was 1000°C. After the furnace reached the desired temperature and a uniform gas flow was maintained, the samples were introduced into the hot zone of the reaction chamber, by a magnet from outside the quartz tube, for 1 hour. After reaction the samples were moved back to the cold zone of the reaction chamber, where a temperature of about 60°C was maintained.

The reaction products were characterized by X-ray diffraction (XRD) (CuKα radiation), transmission electron microscopy (TEM), electron probe microanalysis (EPMA), Auger electron spectroscopy (AES), optical transmission spectroscopy (OTS) and sheet resistivity measurements using a four-point probe.

Thin foils for TEM study were obtained by peeling off the films from the quartz substrate by immersing in very dilute HF (about 1%).

The analyses indicated that the resulting structure had exclusively Type II orientation with more than 99.9% of the structure being oriented parallel to the substrate.

### EXAMPLE 2

A solution of ammonium thiomolybdate was prepared by saturating 50 ml of an aqueous solution of ammonium molybdate (5g) with H₂S. This solution was used as an electrolyte, with a Pt anode and a Ti cathode. A constant current of 1 mA cm⁻² for 20 minutes was passed through the electroplating cell, which was cooled in an ice-water bath.

The layer was analyzed by Auger electron spectroscopy and found to be MoOS₂. It was annealed in 10% H₂S in argon at 700°C for 30 minutes. Subsequent analysis of the annealed film showed it to be MoS₂. The resulting structure was of mixed Type I and Type II orientation.

### EXAMPLE 3

Ammonium molybdate (2g) and elemental sulfur (0.1g) were dissolved in dimethyl sulfoxide (50 ml) at 130°C. This solution was used as an electrolyte in an electrolysis cell using a carbon anode and Ti cathode. A constant current of 0.5 mA cm⁻² was passed for 20 minutes at an electrolyte temperature of 130°C.

The resulting film was found, by electron diffraction, to be composed of MoO₂ crystals. This film was annealed in a mixture of forming gas with 0.1% H₂S at 800°C for 20 minutes, which converted it to MoS₂. The resulting structure was of mixed Type I and Type II orientation.

### EXAMPLE 4

Thin films of tungsten (about 50 nm thick) were ion beam sputtered onto quartz slides, at an argon pressure (in the chamber) of 0.0267 Pa (2 x 10⁻⁴ Torr). The sputtering rate was about 10 nm min⁻¹. The samples were reacted in an open quartz furnace with a flow of H₂S (5-50 cm³ min⁻¹) and forming gas (5% H₂, 95% N₂, 150 cm³ min⁻¹). The reaction temperatures were controlled in the range from 500 to 1000°C. After the furnace reached the desired temperature and a uniform gas flow was maintained, the samples were introduced into the hot zone of the reaction chamber, by a magnet from outside the quartz tube, for times between 5 minutes and 5 hours. After reaction the samples were moved back to the cold zone of the reaction chamber, where a temperature of about 60°C was maintained. The reaction products were characterized as in Example 1.

The results of the analyses are described below. The tungsten layer after deposition was found by XRD as well as by TEM to be either amorphous or with a grain size of 1 nm or less. In order to study systematically the onset of the reaction, the tungsten/quartz specimens were reacted at temperatures between 500 and 1000°C for 30 minutes. EPMA measurements were performed after the reaction. The atomic concentrations of the elements were found to be in a good agreement with the WS₂ stoichiometry and did not depend on the heat treatment conditions within the experimental error of this technique.

It was verified by OTS, XRD, AES and TEM that the onset reaction temperature is 650°C. At this temperature the WS₂ hexagonal 2H polytype (see Powder Diffraction File, ASTM, Philadelphia, PA, card 8 237) was formed. The sheet resistivity measurements were also in agreement with the other techniques and revealed an increase of three orders of magnitude in the resistivity of the layer between 600 and 650°C, indicating the transformation from metallic tungsten to semiconducting WS₂. The AES depth profile taken from such specimens showed uniform distribution of tungsten and sulfur with negligible amounts (less than 1%) of carbon and oxygen in the bulk.

TEM observations demonstrated no change in the film microstructure within the temperature range of from 650 to 900°C, although a slight tendency toward grain growth was observed with increasing reaction temperature as can be seen in the Table below.

| T(°C) | Time (hrs) | Texture | Resistivity | XRD grain size (nm) | TEM grain size (nm) |
|---|---|---|---|---|---|
| 500 | 0.5 | No rxn | 2.7x10⁻³ | | |
| 650 | 0.5 | Type I | 6.1 | | 10 |
| 750 | 0.5 | Type I | 3.1 | | 10-13 |
| 850 | 0.5 | Type I | 2.4 | | 13-15 |
| 1000 | 0.5 | Type II | 1.3 | 30 | 30-200 |
| 1000 | 3.0 | Type II | 1.3 | 100 | 40-350 |
| 1000 | 5.0 | Type II | | 200 | 50-300 |

TEM micrograph and selected area diffraction pattern (SADP) from a specimen following reaction at 750°C for 30 minutes clearly show the lattice image of the VdW planes, showing clear Type I orientation. The lattice spacing is shown to be approximately 6.18 Angstrom. The most intense ring on the SADP was identified with the {002} reflection as expected for Type I texture.

The XRD spectra from such specimens are in good agreement with the TEM results. XRD spectra taken from a specimen following reaction at 650°C for 30 minutes showed the {100} and {110} reflections to be at 2Θ = 32.767° and 2Θ = 58/427°, respectively, which is consistent with Type I orientation.

However, in addition to the Type II orientation, also observable were small amounts (about 1%) of Type I oriented grains. The SADP revealed the absence of almost the entire {002} diffraction ring as expected for such a growth type. The commonly occurring moire patterns indicate that most of the microcrystallites with the VdW parallel orientation are mutually rotated about the c axis, and that the thicknesses of the crystallites are typically much less than the film thickness, which were about 200 nm.

XRD spectra of such specimens (1000°C, 30 minutes) showed only the {001} reflections where 1 = 2n corresponding to the 2H polytype of WS₂) and clearly indicated, in good agreement with the TEM observation, nearly exclusively Type II texture. In this case the intensity of the {002} peak was a few orders of magnitude stronger than for the specimens after reaction at lower temperatures.

It was found that the sulfur supply rate is extremely important in achieving exclusively Type II orientation. Best results were obtained when the samples were introduced into the reaction chamber for 30 minutes at 1000°C in the presence of flowing forming gas only, without the direct addition of H₂S. After this treatment, it was found that the tungsten fully reacted with residual sulfur present in the reaction chamber to give WS₂. Moreover, the WS₂ was found by XRD and TEM to feature exclusively Type II orientation. No crystallites with Type I orientation could be observed in either the image or the SADP. The grain size was not uniform with some grains being as large as 1 µm, but most being noticeably smaller (about 100 nm).

TEM micrographs from a specimen reacted with residual sulfur as described above, followed by 30 minutes reaction at 1000°C with the usual conditions of H₂S and forming gas flow showed an increasing number of the large grains (about 1 µm). This is of importance for photovoltaic applications, where grain size should be as large as possible.

The table above summarizes the orientation, sheet resistivity, and grain sizes as a function of reaction conditions. In addition to the TEM measurement, the grain size was also estimated by measuring the full width at half-maximum of the XRD diffraction peak compared with a single-crystal specimen.

The results described above show that thin films of transition metal dichalcogenides grow in two preferential orientations: Type I (VdW planes perpendicular to the substrate), which is the more common growth pattern, and Type II (VdW planes parallel to the substrate).

It has been discovered that four main factors have an important influence on the texture of the tungsten disulfide thin films: (1) reaction temperature, (2) rate of the sulfur supply, (3) the deposition rate of the sputtered transition metal film, as it relates to the purity of the film and (4) the nature of the substrate.

The interaction between thin films of tungsten and H₂S on quartz begins at 650°C. The interaction is very quick and takes only a few minutes to be completed.

It was demonstrated that, at reaction temperatures lower than 1000°C, the orientation of the WS₂ grains was always of Type I, while at 1000°C most of the specimens exhibited Type II texture. Without in any way limiting the scope of the present invention, it is believed that this phenomenon results from the kinetic conditions controlling the process. In spite of the orientation difference that exists in the two temperature regions, there is no evidence that the reaction at 1000°C (or above) starts with Type I orientation and then transforms to Type II orientation during the process. It was found that when the conditions are not ideal for Type II growth, such as low reaction temperatures or low rates of tungsten deposition, the orientation begins and remains Type I. Further reaction time or post-annealing treatments leads to grain growth but have no effect on the texture.

In contrast with work reported in the literature, which in some cases reported predominantly Type II orientation (see A. Jager-Waldau and E. Bucher, Thin Solid Films, 200 (1991) 157; A. Jager-Waldau et al., ICSFS-6, 29 June-3 July, 1992, Paris), layers made according to the present invention can be made to contain no Type I oriented grains whatsoever. This difference is of great importance, since it is known that even very low concentrations of Type I oriented grains can severely degrade photovoltaic performance (see W. Kautek et al., Ber. Bunsenges. Phys. Chem., 83 (1979) 1000). Also, in contrast with other reported methods, the method described here is readily amenable to scale-up and can therefore be used to deposit films of large areas.

The contamination of the slowly growing tungsten film at low deposition rates is a very important factor affecting the texture. As mentioned above, in this case Type I rather than Type II growth occurs. It is believed that this behavior can be attributed to oxygen and/or water vapor adsorption which is inversely proportional to the deposition rate. If the tungsten film (deposited under normal conditions, i.e. about 10 nm min⁻¹) is first oxidized by heating in air, and then sulfided, there is a greater tendency to Type I orientation compared with unoxidized tungsten.

Without in any way limiting the scope of the present invention, it is believed that the results described above may be explained as follows.

Since high sulfur concentration is associated with Type I growth and low sulfur concentration is conducive of Type II growth, it is suggested that there is competition between diffusion-crystallization in the WS₂ lattice and the reaction of the compound formation. If the reaction is kept at a low rate, as through a low concentration of sulfur, and the diffusion-crystallization processes are speeded up, as through use of high temperatures, the layer will have more time to grow in a Type II orientation, since it is the more energetically favorable orientation, since the reaction is slower than the crystallization.

In certain applications it may be desirable to form superstructures which feature various chemical species. For example, one can form a number of layers wherein the chemical makeup of one or more layers differs from that of an adjoining layer or group of layers. Similarly, each layer may be made up of a single chemical species or may include a mixture of a number of such species.

### EXAMPLE 5

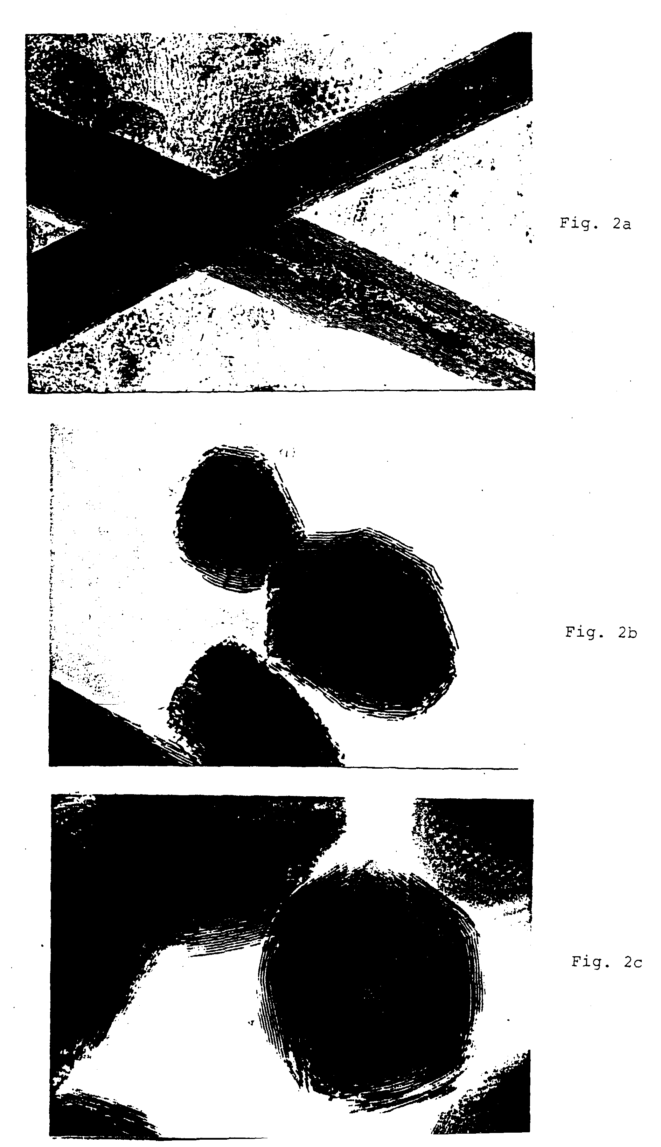

A thin film of tungsten was deposited on quartz as in Example 4. This film was annealed at 1000°C for 70 minutes in an argon flow with residual sulfur from the walls of the quartz reaction tube followed by 60 minutes in a flow of pure H₂. While the film was composed predominantly of flat crystals oriented with the Van der Waals planes parallel to the substrate, some tubes and closed polyhedra (faux fullerenes) of WS₂ were also formed. The tubes were several hundred nm long and several tens of nm in diameter, and were formed of many concentric WS₂ tubes as shown in Figure 2a. Figures 2b and 2c show nested polyhedra of WS₂.

It has thus been found that the WS₂ crystals can, in some cases, curve to form essentially concentric structures of substantially cylindrical shape. These structures have a decided advantage for photovoltaic cell purposes, in that the amount of exposed edge face is much less than for the equivalent flat crystals. Furthermore, we sometimes observe closing of the edge of the tube by what appear to be Van der Waals faces, reducing to essentially zero the exposed edge planes. Such structures may be useful for other purposes, apart from photovoltaic cells, because of their nanoscale structure. Thus, they could, in principle, be used as quantum wires and modified by introducing foreign atoms or molecules either into the Van der Waals gaps between layers (intercalation) or into the hollow center of the tube.

### EXAMPLE 6

Nested polyhedra based on WS₂ were obtained in large quantities and with various structures by the following method. A thin films of W or WOₓ (100 - 300 Angstroms) was deposited on a quartz substrate by electron beam or ion beam deposition. The sample was introduced into the furnace where it is fired for approximately one hour at 950 to 1050°C in the presence of air. This leads to the creation of a stoichiometric trioxide layer as confirmed by various measurements. Subsequently, the quartz tube of the furnace was closed and a stream of H₂S (1 - 5 ml/min) and forming gas (5% H₂, 95% N₂, 50 - 150 ml/min) were passed through the system for one to two hours, usually without altering the temperature. After the samples were allowed to revert to ambient conditions they were taken for various analyses, of which transmission electron microscopy (TEM) with imaging and selected area electron diffraction (SAED) were the most relevant for the determination of the nested polyhedra. Polyhedra were found to be most abundant when the sample was fired at 1050°C.

### EXAMPLE 7

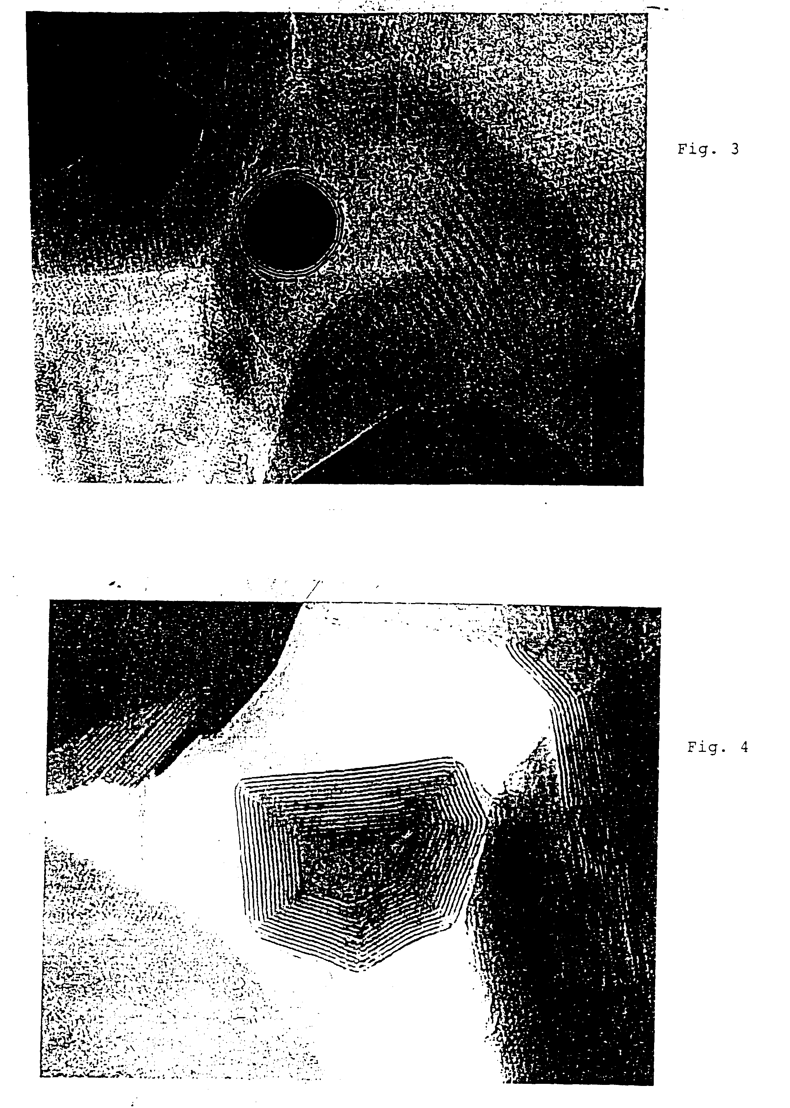

Nested polyhedra based on MoS₂ were produced by using a similar method to that described in Example 6 above. However, since MoO₃ is much more volatile than WO₃, it was necessary to perform the annealing at lower temperatures (950°C), and hence the structures were less abundant, and possibly different in growth mechanism, from those obtained with WS₂. Two typical structures were obtained -- (1) round-shaped polyhedra consisting of a very few layers (2 to 5) and a dark core which is suspected of being of metallic nature, as shown in Figure 3, and (2) hollow structures with many (>10) layers of MoS₂, as shown in Figure 4. The fringe contrast in the polyhedra was preserved on tilting the sample, while the fringe contrast of nearby platelets was lost upon tilting the sample, which is a clear indication in support of the close nature of the polyhedra. This is confirmed also by SAED which showed the diffraction pattern of two perpendicular planes at the same time.

### EXAMPLE 8

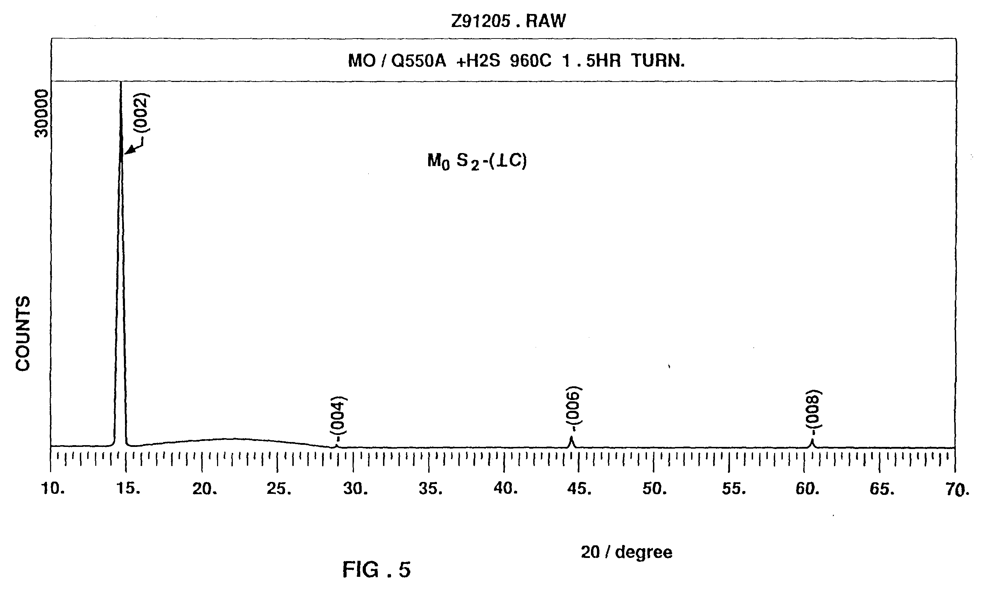

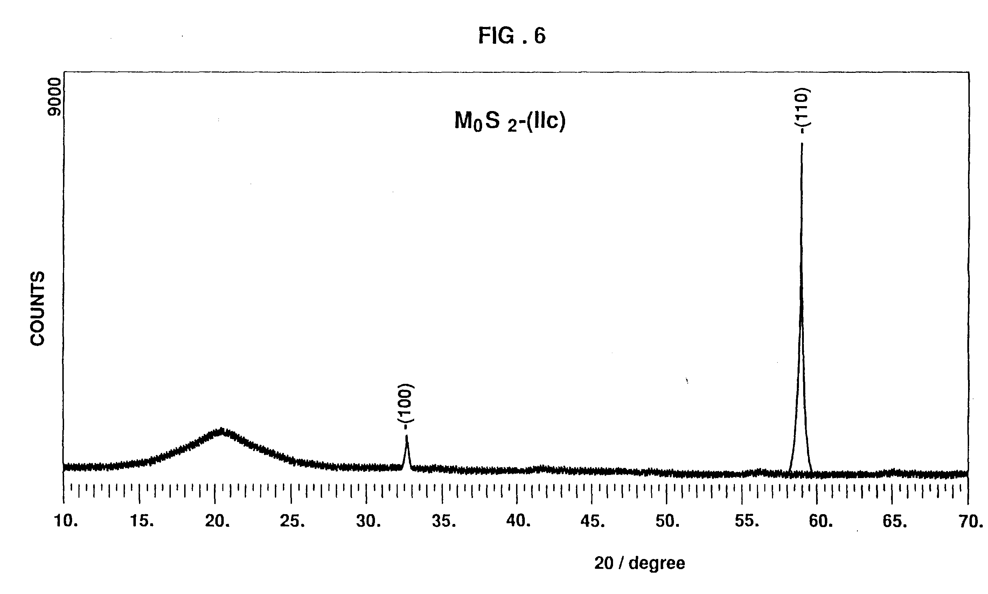

Oriented MoS₂ films were obtained on a quartz substrate by the following procedure. A 240 - 550 Angstrom Mo film was deposited on pre-cleaned quartz substrate by electron beam evaporation. The sample was fired (pre-annealed) for one hour in the atmosphere of the forming gas at 960 - 1000°C. X-ray powder diffraction spectra showed that under these conditions the Mo recrystallized with a typical grain size of one micrometer. Subsequently H₂S was added to the reaction mixture and annealing continued for one to three hours. At 960°C the orientation of the MoS₂ crystallites was almost exclusively Type II structures, as shown in Figure 5. Firing at 1000°C without pre-annealing lead to preferred Type I orientation, as shown in Figure 6.

### EXAMPLE 9

Oriented Type II thick films (2000 Angstroms and above in thickness) of MoSe₂ and WSe₂ were obtained by annealing Mo (W) or MoOₓ (WOₓ) film on a quartz substrate in an atmosphere of forming gas (N₂/H₂ = 95/5) and Se gas at temperatures greater than 950°C for over one hour. The metal (metal oxide) film was obtained by preheating a piece of selenium at 300°C in an auxiliary furnace, outside the main chamber. For film thickness greater than 2000 Angstroms, a repetitive process of metal (or metal oxide) deposition (2000 Angstroms) and annealing was found advantageous. The films exhibited excellent orientation, as confirmed by powder X-ray diffractometry.

### EXAMPLE 10

Nested polyhedra (NP) and nanotubules of MoSe₂ and WSe₂ were obtained by first evaporating a thin film (ca. 200 Angstroms) of MoOₓ (WOₓ) on a quartz substrate and annealing these films in an atmosphere of forming gas (N₂/H₂ = 95/5) and Se gas at temperatures below 850°C for 5-30 minutes. The film was peeled off from the quartz substrate by dipping the entire sample in a 1-5% HF for ca. 10 minutes, and transferred onto Cu grids for examination by transmission electron microscope, or scanning tunneling microscope. Nested polyhedra of radiuses of 5-60 nm were observed. The transformation of the oxide into the NP phase could be described by a series of chemical and physical transformations in which an amorphous phase transforms into the stable (2H) crystalline phase through a metastable phase which consisted of NP. This process resembles the transformation of amorphous carbon soot into bulk graphite, through a metastable fullerene phase. It also resembles the transformation of Al-Mn amorphous alloys into the bulk crystalline phase through a metastable icosahedral phase (Schechtmanite). This similarity lends itself to an alternative process for NP production by quenching the melt (i.e., rapid cooling of the melt, where it exists).

### EXAMPLE 11

NP were also produced by irradiating amorphous MOSₓ (WSₓ) films with an intense electron beam. The amorphous film was produced by a short anneal of the metal-oxide in the reducing atmosphere of the forming gas together with H₂S (S). Depending on the duration and intensity of the beam, the process could take a few tens of minutes to hours. A regime of intermittent irradiation was advantageous for the control of the NP sizes. Other sources of electromagnetic radiation and/or particle beam irradiation, such as intense ion beam, laser zapping, and the like, may also be useful for this purpose.

## Claims

1. A method of preparing a polycrystalline thin film of a transition metal chalcogenide, or mixtures thereof, with layered structure, of type II orientation on a substrate, comprising:
(a) depositing a layer of a transition metal material selected from a transition metal, a compound containing a transition metal and mixtures thereof on the substrate; and
(b) heating said layer in an open system under a gas flow containing one or more chalcogen materials for a time sufficient to allow said transition metal material and said chalcogen material to react and form the oriented polycrystalline thin film, said thin film being nearly exclusively oriented in said type II orientation.

2. A method as in claim 1 wherein said transition metal is tungsten and/or molybdenum and wherein said chalcogen is sulfur and/or selenium.

3. A method as in claim 1 or 2 wherein said depositing is accomplished by a method selected from sputtering, vacuum evaporation, electrodeposition and chemical solution deposition.

4. A method as in any of claims 1 to 3 wherein the substrate is selected from quartz, glass and titanium.

5. A method as in any of claims 1 to 4 wherein the gas flow carries a member of the group consisting of hydrogen sulfide, sulfur selenium and tellurium.

6. A method according to any one of claims 1 to 5 wherein the heating of the layer of said transition metal material is conducted under reducing conditions.

7. A method according to claim 6 wherein the heating is conducted using a gaseous atmosphere which includes hydrogen sulfide or sulfur and forming gas.

8. A method according to claim 7 wherein the forming gas comprises 5% of H₂ and 95% of N₂.

9. An oriented polycrystalline thin film of a transition metal chalcogenide obtainable by the method described in any of claims 1 to 8.

10. A polycrystalline thin film of a transition metal chalcogenide, or mixtures thereof, on a substrate, over 95% of whose the Van der Waals planes are parallel to the substrate surface.

11. A nested polyhedra structure made up of layered transition metal chalcogenides.

12. A nested polyhedra structure as in claim 11 wherein said structure is substantially circular in cross-section.

13. A nested polyhedra structure as in claim 11 wherein said structure is substantially nanotubular.

14. A nested polyhedra structure as in any of claims 10 to 13 obtainable by irradiation with electromagnetic radiation or a particle beam.

15. Nested polyhedra based on WS₂ obtainable by depositing on a quartz substrate by electron beam or ion beam deposition a thin films of W or WOₓ (100 - 300 Angstroms) introducing the sample into a furnace where it is fired for approximately one hour at 950 to 1050°C in the presence of air subsequently closing the quartz tube of the furnace and passing through the system a stream of H₂S (1 - 5 ml/min) and forming gas (5% H₂, 95% N₂, 50 - 150 ml/min) for one to two hours, usually without altering the temperature.

16. Nested polyhedra based on MoS₂ obtainable according to claim 14 using thin films of Mo or MoOₓ and performing the annealing at lower temperatures (950°C).

17. Nested polyhedra of WS₂ obtainable by ion beam sputtering, at an argon pressure (in a chamber) of 2 x 10⁴ Torr and a sputtering rate of about 10 nm min⁻¹ a thin film of tungsten on quartz annealing this film at 1000°C for 70 minutes in an argon flow with residual sulfur from the walls of a quartz reaction tube followed by 60 minutes in a flow of pure H₂.

18. Nested polyhedra and nanotubules of MoSe₂ and WSe₂ obtainable by first evaporating a thin film (ca. 200 Angstroms) of MoOₓ (WOₓ) on a quartz substrate and annealing these films in an atmosphere of forming gas (N₂/H₂ = 95/5) and Se gas at temperatures below 850°C for 5-30 minutes.

19. Nested polyhedra obtainable by irradiating amorphous MoSₓ (WSₓ) films with an intense electron beam, wherein the amorphous film was produced by a short anneal of the metal-oxide in the reducing atmosphere of forming gas together with H₂S (S), for a few tens of minutes to hours.

## Patentansprüche

1. Verfahren zur Herstellung eines polykristallinen Dünnfilms eines Übergangsmetallchalkogenids oder Gemischen davon, mit einer schichtartigen Struktur der Orientierung Typ II auf einem Substrat, umfassend:
(a) Abscheiden einer Schicht eines Übergangsmetallmaterials, ausgewählt aus einem Übergangsmetall, einer ein Übergangsmetall enthaltenden Verbindung und Gemischen davon, auf dem Substrat und
(b) Erhitzen der Schicht in einem offenen System unter einem Gasstrom, der ein oder mehrere Chalkogenmaterialien enthält, für eine ausreichende Zeit, damit sich das Übergangsmetallmaterial und das Chalkogenmaterial umsetzen und den orientierten polykristallinen Dünnfilm ausbilden, wobei der Dünnfilm nahezu ausschließlich in der Orientierung vom Typ II orientiert ist.

2. Verfahren nach Anspruch 1, wobei das Übergangsmetall Wolfram und/oder Molybdän ist und wobei das Chalkogen Schwefel und/oder Selen ist.

3. Verfahren nach Anspruch 1 oder 2, wobei die Abscheidung durch ein Verfahren, ausgewählt aus Sputtern, Vakuumabscheidung, Elektroabscheidung und Abscheidung aus chemischer Lösung, erfolgt.

4. Verfahren nach einem der Ansprüche 1 bis 3, wobei das Substrat ausgewählt ist aus Quarz, Glas und Titan.

5. Verfahren nach einem der Ansprüche 1 bis 4, wobei der Gasstrom einen Stoff der Gruppe Schwefelwasserstoff, Schwefel, Selen und Tellur trägt.

6. Verfahren nach einem der Ansprüche 1 bis 5, wobei das Erhitzen der Schicht des Übergangsmetallmaterials unter reduzierenden Bedingungen ausgeführt wird.

7. Verfahren nach Anspruch 6, wobei das Erhitzen unter Verwendung einer Gasatmosphäre ausgeführt wird, die Schwefelwasserstoff oder Schwefel oder Formiergas einschließt.

8. Verfahren nach Anspruch 7, wobei das Formiergas 5% H₂ und 95% N₂ umfaßt.

9. Orientierter polykristalliner Dünnfilm eines Übergangsmetallchalkogenids, erhältlich durch das Verfahren nach einem der Ansprüche 1 bis 8.

10. Polykristalliner Dünnfilm eines Übergangsmetallchalkogenids oder Gemischen davon auf einem Substrat, wobei über 95% seiner Van der Waals-Ebenen parallel zur Substratoberfläche verlaufen.

11. Struktur aus ineinander geschachtelten Polyedern, hergestellt aus schichtförmigen Übergangsmetallchalkogeniden.

12. Struktur aus ineinander geschachtelten Polyedern nach Anspruch 11, wobei der Querschnitt der Struktur im wesentlichen kreisförmig ist.

13. Struktur aus ineinander geschachtelten Polyedern nach Anspruch 11, wobei die Struktur im wesentlichen nanoröhrenförmig ist.

14. Struktur aus ineinander geschachtelten Polyedern nach einem der Ansprüche 10 bis 13, erhältlich durch Bestrahlung mit elektromagnetischer Strahlung oder einem Teilchenstrahl.

15. Ineinander geschachtelte Polyeder auf der Basis von WS₂, erhältlich durch Abscheiden von Dünnfilmen von W oder WOₓ (100 - 300 Angström) auf einem Quarzsubstrat durch Elektronenstrahl- oder Ionenstrahlabscheidung, Einführen der Probe in einen Ofen, wo sie für etwa eine Stunde bei 950 bis 1050°C in Gegenwart von Luft hitzebehandelt wird, anschließend Schließen des Quarzrohrs des Ofens und Durchleiten eines H₂S-Stroms (1 - 5 ml/min) und eines Formiergases (5% H₂, 95% N₂, 50 - 150 ml/min) durch das System für ein bis zwei Stunden gewöhnlich ohne Ändern der Temperatur.

16. Ineinander geschachtelte Polyeder auf der Basis von MoS₂, erhältlich nach Anspruch 14, unter Verwendung von Dünnfilmen von Mo oder MoOₓ und Ausführen der Hitzebehandlung bei niedereren Temperaturen (950°C).

17. Ineinander geschachtelte Polyeder von WS2, erhältlich durch Ionenstrahlsputtern eines Wolframdünnfilms auf Quarz bei einem Argondruck (in einer Kammer) von 2 x 10⁻⁴ Torr und mit einer Sputterrate von etwa 10 nm min⁻¹, Hitzebehandlung dieses Films bei 1000°C für 70 Minuten in einem Argonstrom mit restlichem Schwefel aus den Wänden des Quarzreaktionsrohres, gefolgt von 60 Minuten in einem Strom aus reinem Wasserstoff.

18. Ineinander geschachtelte Polyeder und in Form von Nanoröhrchen von MoSe2 und WSe2, erhältlich durch zunächst Aufdampfen eines Dünnfilms (ca. 200 Angström) von MoOₓ (WOₓ) auf ein Quarzsubstrat und Hitzebehandlung dieser Filme in einer Atmosphäre von Formiergas (N₂/H₂ = 95/5) und Se-Gas bei Temperaturen unterhalb 850°C für 5-30 Minuten.

19. Ineinander geschachtelte Polyeder, erhältlich durch Bestrahlen von amorphen MoSₓ (WSₓ) Filmen mit einem starken Elektronenstrahl, wodurch der amorphe Film durch eine kurze Hitzebehandlung des Metalloxids in der reduzierenden Atmosphäre des Formiergases zusammen mit H2S (S) für einige zehn Minuten bis Stunden erzeugt wurde.

## Revendications

1. Procédé de préparation d'un film mince polycristallin d'un chalcogénure de métal de transition ou l'un de ses mélanges, de structure lamellaire, d'orientation de type II, sur un substrat, ledit procédé comprenant:
(a) le dépôt d'une couche d'un matériau de métal de transition choisi parmi les métaux de transition, les composés contenant un métal de transition et leurs mélanges, sur le substrat ; et,
(b) le chauffage de ladite couche dans un système ouvert sous un courant gazeux contenant un ou plusieurs matériaux chalcogènes pendant un temps suffisant pour permettre audit matériau de métal de transition et audit matériau chalcogène de réagir pour former le film mince polycristallin orienté, ledit film étant presque exclusivement orienté selon ladite orientation de type II.

2. Procédé suivant la revendication 1, dans lequel ledit métal de transition est le tungstène et/ou le molybdène, et ledit chalcogène est le soufre et/ou le sélénium.

3. Procédé suivant la revendication 1 ou 2, dans lequel ledit dépôt est effectué selon une méthode choisie parmi les projection, évaporation sous-vide, électrodéposition et dépôt de solution chimique.

4. Procédé suivant l'une quelconque des revendications 1 à 3, dans lequel le substrat est choisi parmi les quartz, verre et titane.

5. Procédé suivant l'une quelconque des revendications 1 à 4, dans lequel le courant gazeux véhicule un élément de l'ensemble constitué par les sulfure d'hydrogène, soufre, sélénium et tellure.

6. Procédé suivant l'une quelconque des revendications 1 à 5, dans lequel le chauffage de la couche dudit matériau de métal de transition est effectué dans des conditions réductrices.

7. Procédé suivant la revendication 6, dans lequel le chauffage est effectué en utilisant une atmosphère gazeuse qui comprend du sulfure d'hydrogène ou du soufre et un moyen formant un gaz.

8. Procédé suivant la revendication 7, dans lequel le moyen formant un gaz comprend 5 % de H₂ et 95 % de N₂.

9. Film mince polycristallin orienté d'un chalcogénure de métal de transition pouvant être obtenu par le procédé décrit dans l'une quelconque des revendications 1 à 8.

10. Film mince polycristallin d'un chalcogénure de métal de transition, ou l'un de ses mélanges, sur un substrat, dont plus de 95 % des plans de Van der Waals sont parallèles à la surface du substrat.

11. Structure polyédrique emboîtée faite de chalcogénures lamellaires de métal de transition.

12. Structure polyédrique emboîtée suivant la revendication 11, dans laquelle ladite structure est essentiellement circulaire en section.

13. Structure polyédrique emboîtée suivant la revendication 11, dans laquelle ladite structure est essentiellement nanotubulaire.

14. Structure polyédrique emboîtée suivant l'une quelconque des revendications 10 à 13, pouvant être obtenue par irradiation au moyen d'un rayonnement électromagnétique ou d'un faisceau de particules.

15. Polyèdre emboîté à base de WS₂ pouvant être obtenu par dépôt sur un substrat en quartz par déposition au moyen d'un faisceau électronique ou ionique de films minces de W ou WOₓ (100-300 Å), introduction dans un four où est effectué un grillage pendant environ une heure à 950-1050°C en présence d'air, fermeture ensuite du tube de quartz du four et passage à travers du système d'un courant de H₂S (1-5 ml/min) et d'un moyen formant un gaz (5 % H₂, 95 % N₂ ; 50-150 ml/min) pendant une à deux heures, généralement sans modifier la température.

16. Polyèdre emboîté à base de MoS₂ pouvant être obtenu selon la revendication 14, en utilisant des films minces de Mo ou MoOₓ et en procédant au recuit à des températures inférieures (950°C).

17. Polyèdre emboîté à base de WS₂ pouvant être obtenu à partir d'un film mince de tungstène sur quartz par projection d'un faisceau ionique sous une pression d'argon (dans la chambre) de 2 x 10⁻⁴ Torr et à une vitesse de projection d'environ 10 nm.min⁻¹, recuit de ce film à 1000°C pendant 70 minutes sous courant d'argon avec du soufre résiduel des parois d'un tube de réaction en quartz puis pendant 60 minutes d'un courant de H₂ pur.

18. Polyèdre emboîté et nanotubes de MoSe₂ et WSe₂ pouvant être obtenus par évaporation d'un film mince (environ 200 Å) de MoOₓ (WOₓ) sur un substrat de quartz et recuit de ces films dans une atmosphère formant un gaz (N₂/H₂ = 95/5) et de gaz Se à des températures inférieures à 850°C pendant 5-30 minutes.

19. Polyèdre emboîté pouvant être obtenu par irradiation de films amorphes de MoSₓ (WSₓ) au moyen d'un faisceau électronique intense, où le film amorphe a été produit par un court recuit d'oxyde métallique dans une atmosphère réductrice d'un moyen formant gaz avec H₂S (S), pendant une durée de quelques dizaines de minutes à plusieurs heures.
